Europäisches Patentamt

European Patent Office

Office européen des brevets

(19)

(11) Numéro de publication : **0 334 735 B1**

(12) **FASCICULE DE BREVET EUROPEEN**

(45) Date de publication du fascicule du brevet :
**11.11.92 Bulletin 92/46**

(51) Int. Cl.$^5$ : **G11C 19/28**

(21) Numéro de dépôt : **89400764.0**

(22) Date de dépôt : **17.03.89**

(54) **Dispositif de lecture des quantités de charges électriques fournies par des photodiodes à substrat semi-conducteur.**

(30) Priorité : **23.03.88 FR 8803792**

(43) Date de publication de la demande :
**27.09.89 Bulletin 89/39**

(45) Mention de la délivrance du brevet :
**11.11.92 Bulletin 92/46**

(84) Etats contractants désignés :
**DE FR GB NL**

(56) Documents cités :
**EP-A- 0 168 291
US-A- 3 969 634
US-A- 4 236 830
US-A- 4 242 599**

(73) Titulaire : **THOMSON-CSF
51, Esplanade du Général de Gaulle
F-92800 Puteaux (FR)**

(72) Inventeur : **Prieur-Drevon, Pascal
Thomson-CSF SCPI
Cedex 67 F-92045 Paris la Défense (FR)**

(74) Mandataire : **Guérin, Michel et al
THOMSON-CSF SCPI
F-92045 PARIS LA DEFENSE CEDEX 67 (FR)**

EP 0 334 735 B1

Jouve, 18, rue Saint-Denis, 75001 PARIS

## Description

La présente invention concerne un dispositif de lecture des quantités de charges électriques fournies par des photodiodes à substrat semi-conducteur, fonctionnant en stockage capacitif.

Cette invention s'applique plus particulièrement aux matrices de photodiodes, dans lesquelles ces photodiodes sont disposées aux intersections de lignes et de colonnes, et peuvent avoir une capacité importante.

On connaît, notamment par le brevet EP-A-0168 291 au nom de la demanderesse, un dispositif de lecture de la quantité de charges électriques fournies par des photodiodes disposées sous forme de matrices ou de barrettes. Ce dispositif comporte des moyens de stockage qui permettent de créer dans le substrat des photodiodes, des puits de potentiel de stockage ; ces puits correspondent respectivement à chaque ligne ou à chaque colonne de la matrice, pour stocker successivement, par ligne ou par colonne, les charges provenant respectivement des photodiodes de chaque ligne ou chaque colonne. Ces moyens de stockage sont en fait comparables à un registre tampon, à entrées parallèles, permettant de stocker successivement les charges provenant des photodiodes de chaque ligne ou chaque par colonne, à la suite d'un balayage de la matrice par ligne ou par colonne. Ce dispositif connu comporte aussi un registre à décalage, de type à "couplage de charges" (en anglais "charge coupled device" ou CCD de manière abrégée), à entrées parallèles et à sortie série.

Ce registre à décalage, à substrat semi-conducteur, comporte des moyens de commande pour créer des puits de potentiel, et des potentiels de transfert, dans le substrat, pour faire circuler des charges électriques dans celui-ci. Ces moyens de commande sont essentiellement constitués par des électrodes (ou grille) auxquelles sont appliquées des tensions de commande qui permettent de créer les puits de potentiel de transfert, souvent en relation avec des zones dopées ou implantées de différents types dans le substrat. Grâce à ces potentiels de transfert, les charges reçues par le registre sont décalées, de puits en puits, vers une extrémité de ce registre, qui est couplée à des moyens de lecture. Cette extrémité peut être constituée par une diode semi-conductrice de stockage de charges, reliée à un amplificateur lui-même relié à un appareil de mesure, ou à un circuit de traitement.

Enfin, ce dispositif connu comporte, pour chaque moyen de stockage de charges, un moyen de transfert de charges, à substrat semi-conducteur, (tel qu'un transistor MOS par exemple), constituant l'entrée latérale du registre à décalage, pour transférer des charges contenues dans un puits de stockage, vers un puit de potentiel de réception commun à ce moyen de transfert et au registre à décalage. Les charges ainsi transférées sont ensuite acheminées vers l'extrémité du registre, par décalages successifs. Souvent, lorsque la quantité de charges stockées est faible, ou lorsque les charges stockées sont d'un signe différent de celui des charges que peut véhiculer le registre à décalage, il est connu d'utiliser des moyens de transfert à "écrémage" pour assurer un transfert efficace. Ces moyens de transfert à écrémage sont généralement couplés à des moyens d'injection de charges d'entraînement dans les puits de réception, communs aux moyens de transfert et au registre à décalage. Ces moyens d'injection sont connus, les charges injectées étant créées soit par des tensions électriques appliquées à des électrodes reposant sur le substrat des moyens de transfert, soit par des rayons lumineux appliqués à des diodes semi-conductrices proches des moyens de transfert. Lorsque les charges d'entraînement ont été injectées dans les puits de potentiel de réception, les tensions appliquées aux électrodes ou moyens de commande des moyens de transfert, provoquent grâce aux potentiels de transfert dans le substrat, le déplacement des charges d'entraînement contenues dans chaque puits de réception, vers le puits de stockage correspondant, puis inversement, le déplacement des charges stockées et des charges d'entraînement vers le puits de réception. Les charges stockées et les charges d'entraînement ainsi ajoutées algébriquement sont alors acheminées vers l'extrémité de lecture du registre, par décalages successifs.

Or, le mécanisme de transfert par écrémage décrit ci-dessus manque de rapidité et d'efficacité dans certains cas.

Il est connu que lorsque la capacité des moyens de stockage (photodiodes) est grande, le transfert par les moyens de transfert des charges stockées demande un certain temps pour être efficace, à moins qu'on ne dispose d'une charge d'entraînement importante, ce qui conduit à surdimensionner le registre à décalage (CCD). Cette lenteur du transfert des moyens de stockage vers le registre à décalage est d'autant plus sensible lorsque les charges stockées sont d'un signe différent de celui des charges transférées par le registre à décalage car dans ce cas la charge stockée se soustrait à la charge d'entraînement et la résultante ne peut pas être transférée avec une bonne efficacité.

Une solution connue, dans le cas où la charge stockée - quel que soit son signe - ne peut pas être transférée intégralement en une seule fois, consiste à la fractionner et à la transférer en plusieurs fois de manière à en cumuler les différentes fractions à l'extrémité de lecture du registre à décalage (méthode connue sous l'appellation de "cumul de lignes".

Dans l'état actuel de la technique, pour chaque ligne ou chaque colonne, après chaque transfert des charges stockées et des charges d'entraînement dans des puits de réception du registre à décalage, les charges ainsi ajoutées sont transférées par décalages successifs, vers l'extrémité de lecture du registre où les différentes valeurs de leurs quantités mesurées sont mémorisées. Le registre étant alors vide, pour cette même ligne ou cette même colonne, on effectue un autre transfert des charges stockées et des charges d'entraînement vers les puits de reception du registre à décalage. Ces charges ajoutées sont à nouveau décalées vers l'extrémité du registre pour que les valeurs des mesures de leurs quantités soient de nouveau mémorisées mais après un cumul avec les valeurs précédemment mémorisées, pour les diodes correspondantes de la ligne ou de la colonne considérée.

Ce type de dispositifs a pour inconvénient de nécessiter une mémoire de ligne ou de colonne extérieure au registre à décalage, dans laquelle il est nécessaire de faire un cumul des valeurs mesurées de quantités de charges pour chaque diode ; cet inconvénient qui rend le dispositif coûteux n'est pas le seul.

Un inconvénient bien plus important résulte du fait qu'après chaque transfert, pour les photodiodes d'une ligne ou d'une colonne vers les puits de potentiel de réception, il faut vider tout le registre à décalage, ce qui nécessite un grand nombre de décalages pendant lesquels chaque photodiode de ligne ou de colonne continue à accumuler des charges. Si la période nécessaire pour vider le registre à décalage est trop importante, toutes les charges accumulées ne peuvent être mesurées, et il y a saturation des photodiodes. Il se produit alors un effet dit d'éblouissement (ou Blooming en anglais) des photodiodes, très préjudiciable à l'obtention d'images de bonne qualité partir de la matrice ainsi utilisée.

L'invention a pour but de remédier à ces inconvénients et notamment de réaliser un dispositif de lecture des quantités de charges électriques fournies par une matrice de photodiodes grâce auquel il n'est pas nécessaire pour lire efficacement chaque ligne ou colonne de vider complètement le registre à décalage plusieurs fois et de mémoriser et cumuler les charges mesurées après chacune de ces lectures. Le dispositif de l'invention évite la saturation des diodes et permet d'accroître très sensiblement la vitesse de balayage de ligne ou de colonne, pour un niveau de signal qui peut être égal ou même supérieur à la charge transportable par le registre à décalage.

L'invention a pour objet un dispositif de lecture des quantités de charges électriques fournies par des photodiodes à substrat semi-conducteur disposées aux intersections de lignes et de colonnes d'une matrice, comportant un ensemble, des moyens de stockage pour créer dans le substrat des photodiodes, des puits de potentiel de stockage correspondant respectivement à chaque colonne ou à chaque ligne, pour stocker successivement ligne par ligne ou colonne par colonne, les charges provenant respectivement des photodiodes de chaque ligne ou chaque colonne, un registre à décalage à transfert de charge et à substrat semi-conducteur, ce registre comportant des moyens de commande pour créer des puits de potentiel et des potentiels de transfert dans le substrat du registre à décalage, pour faire circuler des charges électriques dans ce registre, vers une extrémité de sortie de ce registre couplée à des moyens de lecture de quantités de charges et pour chaque moyen de stockage de charges, un moyen de transfert de charges à substrat semi-conducteur, ce moyen de transfert étant muni de moyens de commande pour créer dans ce dernier substrat des potentiels de transfert et un puits de potentiel de réception des charges contenues dans le puits de stockage correspondant, les puits le potentiel de réception des moyens le transfert correspondant aux différents puits de stockage étant aussi des puits de potentiel du registre à décalage et des moyens d'injection de charges d'entrainement dans les puits ce potentiel de réception, les moyens de commande de chaque moyen de transfert provoquant le transfert des charges d'entraînement contenues dans le puits de réception de ce moyen de transfert, vers le puits de stockage correspondant, puis le transfert des charges d'entraînement et d'au moins une partie des charges stockées dans le puits de stockage, vers le puits de réception, caractérisé en ce que le registre à décalage comporte pour chaque photodiode n étages successifs, n étant un nombre entier supérieur à 1, n-1 de ces étages créant n-1 puits de potentiel intermédiaires entre le puits de potentiel de réception correspondant à ladite photodiode et la photodiode voisine pour la même ligne ou la même colonne, et un étage commun au registre à décalage et au moyen de transfert correspondant à ladite photodiode et créant ledit puits de potentiel de réception, la quantité de charges contenues dans chaque puits de stockage étant prise en compte par le registre à décalage après un nombre n de transferts de charges stockées et de charges d'entraînement vers le registre à décalage et un nombre n-1 de décalages, les moyens d'injection de charge d'entraînement injectant des charges d'entraînement dans tous les puits de potentiel de réception du registre à décalage avant chaque transfert de charges vers ces puits de réception, la quantité de charges à lire pour chaque photodiode étant lue après n transferts de charges stockées.

Selon une caractéristique préférée de l'invention, les moyens d'injection de charges d'entraînement sont des moyens parallèles de transfert de charges d'entraînement qui injectent respectivement ces charges d'entraînement en quantités égales dans les puits de potentiel de réception, avant tout transfert de ces charges d'entraînement vers les puits de potentiel de stockage correspondants.

Selon une autre caractéristique préférée, les moyens d'injection de charges d'entraînement sont des moyens de transfert qui injectent ces charges d'entraînement à une extrémité d'entrée du registre à décalage, opposée à l'extrémité de lecture pour que, par décalages successifs, tous les puits de potentiel du registre contiennent respectivement des charges d'entraînement en quantités égales, avant le premier transfert de charges d'entraînement vers les puits de potentiel de stockage, une nouvelle quantité de charges d'entraînement étant injectée à l'extrémité d'entrée au cours de chaque décalage qui suit un transfert de charges d'un puits de stockage vers un puits de réception.

Selon une autre caractéristique préférée, le registre à décalage est réalisé sur un substrat de type P, différent dudit substrat desdits moyens de stockage et desdits photodiodes (qui sont de type P sur substrat de type N).

Selon une autre caractéristique préférée, le registre à décalage est réalisé sur un substrat de type P, lu même type que ledit substrat des dits moyens de stockage et desdits photodiodes (qui sont de type N sur substrat de type P).

Les caractéristiques et avantages de l'invention ressortiront mieux de la description qui va suivre, donnée en référence aux dessins annexés dans lesquels :

- la figure 1 représente schématiquement un dispositif conforme à l'invention, pour la lecture des quantités de charges électriques fournies par des photodiodes,
- les figures 2A à 2E sont des diagrammes qui représentent schématiquement des puits de potentiel et des potentiels de transfert intervenant dans un moyen de stockage et un moyen de transfert correspondant du dispositif de l'invention,
- les figures 3A, 3B, 3C, 3D, 3E et 3F sont des diagrammes représentant des puits de potentiel et des potentiels de transfert intervenant dans le registre à décalage du dispositif de l'invention, lors de la mise en oeuvre de celui-ci.

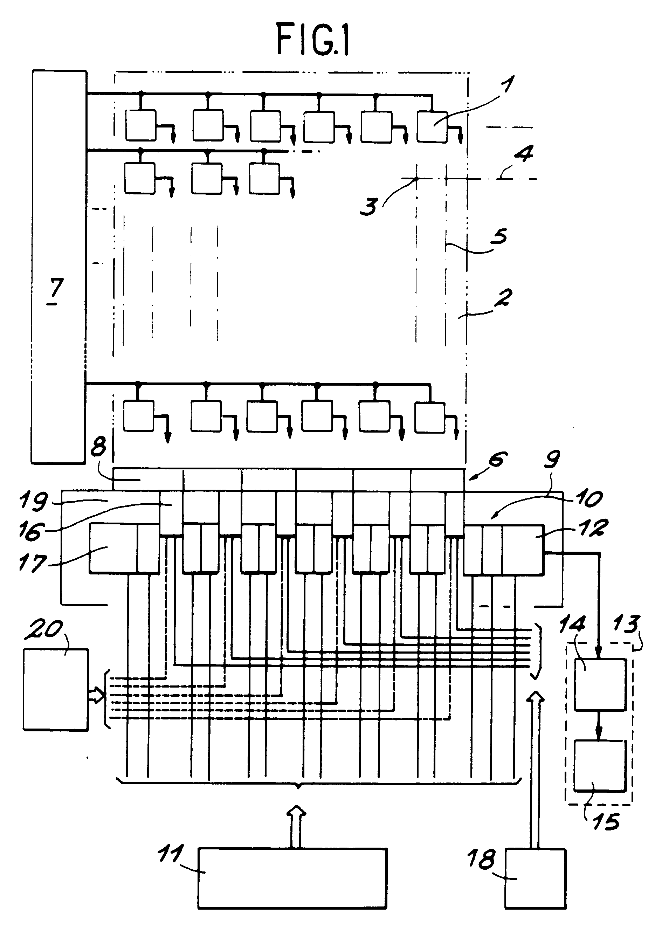

Le dispositif conforme à l'invention, représenté schématiquement sur la figure 1, permet la lecture des quantités de charges électriques fournies par des photodiodes 1 à substrat semi-conducteur 2. Ces photodiodes sont disposées respectivement aux intersections de lignes 4 et de colonnes 5 de manière à former une matrice.

Le dispositif comporte un ensemble 6 de moyens de stockage 8 qui créent, comme on le verra plus loin en détail, des puits de potentiel de stockage correspondant respectivement à chaque colonne ou à chaque ligne. Ces moyens de stockage permettent de stocker successivement ligne par ligne ou colonne par colonne, les charges provenant respectivement des photodiodes de chaque ligne ou chaque colonne de la matrice. Dans l'exemple de réalisation représenté sur cette figure, on suppose que la matrice de photodiodes est une matrice à balayage de lignes. Les moyens de commande de balayage sont connus dans l'état de la technique et sont représentés en 7. Chaque moyen de stockage 8 de l'ensemble 6 permet donc ici de stocker les charges de chaque ligne de photodiodes, les lignes étant balayées successivement. Chaque moyen de stockage 8 peut être constitué, par exemple, par une électrode en regard de la colonne correspondante, reposant sur une couche isolante recouvrant le substrat 2 ; une tension électrique est appliquée à cette électrode pour créer un puits de potentiel de stockage, dans le substrat semi-conducteur, en regard de l'électrode (non représentée).

Le dispositif comporte aussi un registre à décalage 10, à substrat semi-conducteur 9, de type "à transfert de charges" ("charge coupled device" ou CCD en abrégé et en anglais). Ce registre comporte des moyens de commande constitués par une source électrique de tension 11, permettant de façon connue, d'appliquer à des électrodes (non représentées sur la figure), reposant sur une couche isolante recouvrant le substrat 9, des tensions qui créent des puits de potentiel et des potentiels de transfert dans ce substrat. Ces potentiels de transfert et ces puits permettent de faire circuler des charges électriques dans le registre, vers une extrémité de sortie 12, couplée à des moyens de lecture 13 des quantités de charges parvenant à l'extrémité du registre. L'extrémité 12 peut par exemple comporter une électrode finale (non représentée) reposant sur la couche isolante qui recouvre le substrat 9; une tension électrique est appliquée à cette électrode finale pour créer dans le substrat un puits de potentiel final dans lequel parviennent les charges décalées dans le registre.

Les moyens de lecture 13 comprennent, de façon connue, un amplificateur 14 relié à une électrode de mesure (non représentée) reposant sur la couche isolante qui recouvre le substrat, au voisinage de l'extrémité 12. Une sortie de l'amplificateur 14 fournit un courant ou une tension qui est mesuré par un appareil de lecture 15, capable de mémoriser ces charges. Le dispositif comporte aussi, pour chaque moyen 8 de stockage de charges, un moyen 16 de transfert de charges, à substrat semi-conducteur 9. Ce moyen de transfert, connu dans l'état de la technique, est muni de moyens de commande, tels que des électrodes (non représentées), qui reposent sur la couche isolante recouvrant le substrat 9, et auxquelles sont appliquées des tensions électriques de commande, fournies par une source 18. Les moyens de commande de l'ensemble 19 des moyens de transfert, créent dans le substrat 9, comme on le verra plus loin en détail, des barrières de potentiel de transfert et des puits de potentiel de réception correspondant respectivement aux puits de stockage des moyens de stockage 6. Ces puits de potentiel de réception sont aussi, comme on le verra plus loin en détail, des puits de potentiel du registre à décalage 10. Ils permettent le transfert vers le registre à décalage 10, des charges stockées par les moyens de stockage et qui proviennent respectivement d'une ligne de photodiodes, dans l'exemple de réalisation représenté, à balayage de lignes.

Enfin, dans un premier mode de réalisation le dispositif comporte des moyens 17 d'injection de charges d'entraînement dans le registre à décalage 10, à une extrémité d'entrée de ce registre. Ces moyens d'injection peuvent être constitués de façon connue par une électrode (non représentée) reposant sur la couche isolante qui recouvre le substrat 9, et à laquelle est appliquée une tension créant des charges d'entraînement dans ce substrat.

Comme on le verra plus loin en détail, ces charges d'entraînement injectées à l'entrée du registre à décalage progressent dans celui-ci, à chaque décalage, vers l'extrémité de sortie du registre. Ces charges d'entraînement sont injectées en quantités égales à chaque décalage et notamment dans les puits de réception.

Dans un autre mode de réalisation du dispositif, les moyens d'injection de charges d'entraînement sont des moyens parallèles 20 de transfert, connus dans l'état de la technique, qui injectent des charges d'entraînement, respectivement en quantités égales, dans les puits de potentiel de réception du registre à décalage, après chaque décalage.

Comme on le verra plus loin en détail, les moyens de commande de chaque moyen de transfert provoquent le transfert des charges d'entraînement contenues dans chaque puits de réception des moyens de transfert, vers les puits de stockage correspondants, puis inversement, le transfert, vers les puits de réception, des charges d'entraînement et d'au moins une partie des charges stockées dans les puits de stockage correspondant respectivement aux puits de réception. Ce transfert a double sens est obtenu grâce aux barrières de potentiel de transfert créées dans le substrat 9, par les moyens de commande décrits plus haut et qui peuvent être constitués par un transistor MOS commandé en tension. Ce processus de transfert à double sens est connu sous le nom de processus "d'écrémage".

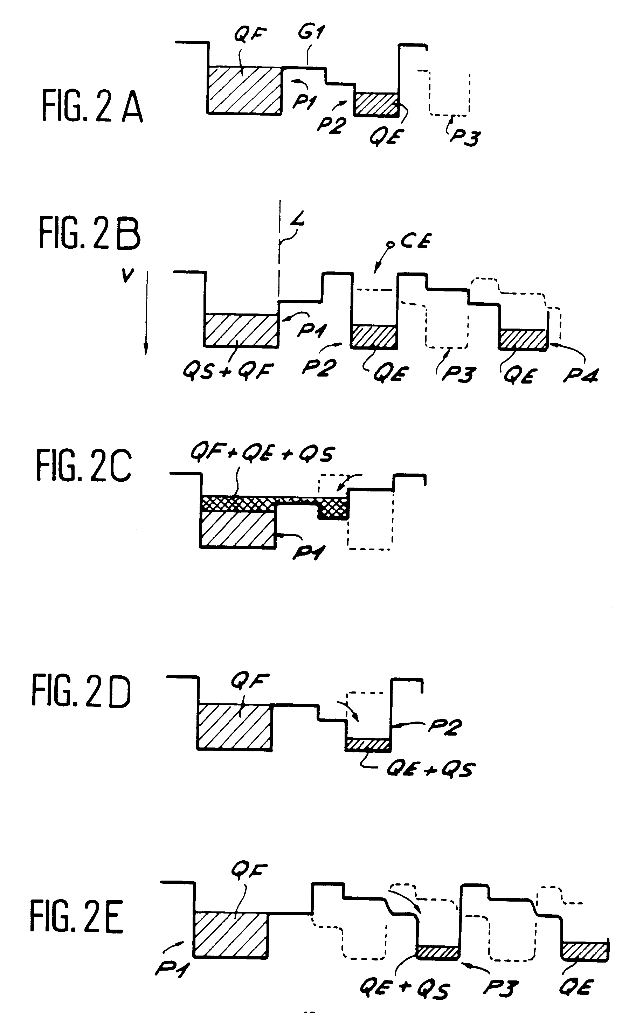

Les figures 2A à 2E permettent de mieux comprendre le fonctionnement des moyens de transfert et notamment le déroulement du processus d'écrémage mis en oeuvre dans le dispositif de l'invention. Les figures 2A à 2E sont des diagrammes qui représentent les puits de potentiel et les potentiels de transfert qui interviennent dans le substrat 2 d'un moyen 8 de stockage des charges, et dans le substrat 9 d'un moyen de transfert 16 correspondant.

Le diagramme des figures 2A et 2B représente un puits de potentiel de stockage P1 du moyen 8, un puits de potentiel de réception P2, commun au moyen de transfert 16 et au registre à décalage 10, et des puits de potentiel tels que P3, du registre à décalage.

Les potentiels sont croissants dans les substrats, dans le sens de la flèche V. La ligne L en traits interrompus délimite la séparation entre le substrat 2 des moyens de stockage et des photodiodes, et le substrat 9 des moyens de transfert et du registre à décalage. Ce diagramme représente schématiquement la quantité de charges Qs contenue dans le puits de stockage P1 d'un moyen de stockage, ces charges provenant d'une photodiode d'une ligne par exemple, et ayant été transférées dans ce puits, lors du balayage de la matrice. Avant que les charges Qs de la photodiode soient transférées dans ce puits P1, il contient une quantité de charges QF fixe définie par le niveau de la grille G1 lors du dernier écrémage (fig. 2A).Ensuite il contient une quantité Qf+Qs (figure 2B). Le puits de potentiel P2 des moyens de transfert, qui est aussi l'un des puits du registre à décalage, contient une quantité QE de charges d'entraînement CE injectées dans ce puits par des décalages successifs, à partir d'une extrémité du registre, ou par une injection latérale, comme indiqué plus haut.

Pour des raisons qui seront expliquées plus loin en détail, le puits P4 du registre à décalage contient aussi une quantité de charges QE, ce qui est inévitable dans le cas d'une injection de QE par l'extrémité d'entrée du registre à décalage.

Le diagramme de la figure 2C représente une étape suivante du processus de transfert de charges. Les tensions appliquées aux électrodes du moyen de transfert 8 sont telles que les potentiels de transfert dans le substrat 9 varient et que les charges d'entraînement CE contenues dans le puits de réception P2 sont transférées vers le puits de stockage P1 et se mélangent aux charges déjà stockées dans ce puits et qui proviennent de la photodiode correspondante. Ce transfert permet de mélanger des charges stockées et des charges d'entraînement, en quantité QE+QS. Lorsque les photodiodes et les moyens de stockage présentent des zones dopées de type P dans un substrat semi-conducteur de type N, et que le registre à décalage présente un substrat de type P, les charges fournies par les diodes et contenues dans les puits de stockage sont des charges positives, tandis que les charges contenues dans les puits de potentiel du registre à décalage, sont des électrons (ce qui est le cas de la figure 2). Il est nécessaire dans ce cas que la quantité QE de charges injectées dans les puits de potentiel du registre à décalage, soit plus importante en valeur absolue, que la quantité de charges Qs stockées à transférer.

Au contraire, lorsque les photodiodes et les moyens de stockage présentent des zones de type N dans un substrat P, et que le registre à décalage est lui-même de substrat P, les charges stockées et les charges d'entraînement sont des électrons ; la seule limitation est alors la quantité maximum de charges qui peuvent être admises dans les puits de potentiel du registre à décalage.

La figure 2D représente schématiquement l'étape suivante du processus de transfert de charges vers le registre à décalage et plus précisément vers le puits de potentiel de réception P2 commun au moyen de transfert considéré et au registre à décalage. Les moyens de commande du moyen de transfert créent dans le substrat des moyens de transfert, des potentiels de transfert provoquant la circulation d'une quantité de charges QE+QS vers le puits de potentiel P2.

Ensuite, comme le montre schématiquement la figure 2E, un décalage est effectué, grâce à des potentiels de transfert du registre à décalage, actionné par ses moyens de commande. La quantité de charges QE+QS est transférée dans le puits de potentiel P3 du registre à décalage tandis qu'une quantité QE de charges d'entraînement est injectée dans le puits de potentiel de réception P2.

Le processus recommence alors de manière identique pour transférer une nouvelle quantité de charges stockées. Le nombre n de transferts ainsi éffectués pour chaque photodiode est choisi en fonction de la quantité de charges stockées, c'est-à-dire en fonction des caractéristiques des photodiodes utilisées et de l'éclairement maximum que doit subir la matrice. Le nombre de transferts correspond en fait au pas ou nombre de cellules du registre à décalage, entre chaque paire de photodiodes d'une ligne ou d'une colonne, selon le type de balayage utilisé.

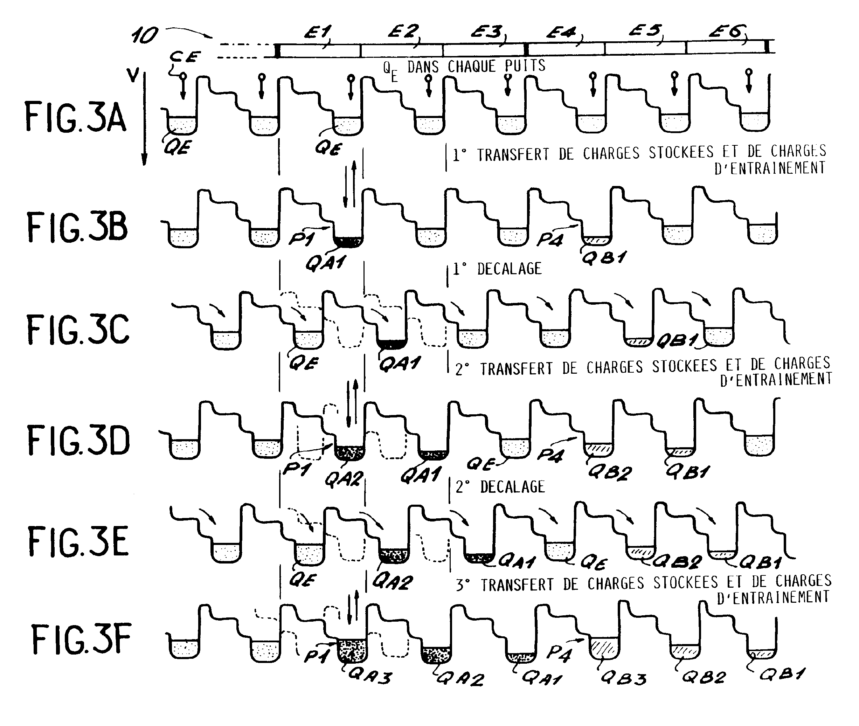

Les figures 3A à 3F vont permettre de mieux comprendre le fonctionnement du dispositif et plus particulièrement la structure du registre à décalage. Ces figures sont des diagrammes qui représentent les puits de potentiel et les potentiels de transfert V dans le substrat du registre à décalage et des moyens de transfert, à différents instants.

Sur le diagramme de la figure 3A, on a représenté les puits de potentiel du registre à décalage avant tout transfert des charges stockées pour chaque photodiode d'une ligne ou d'une colonne, vers les puits de réception respectifs de ce registre. Les puits de potentiel du registre contiennent tous une quantité QE de charges d'entraînement CE injectées latéralement ou par une extrémité du registre, par décalages successifs vers la droite de la figure. On a représenté schématiquement sur la figure des étages successifs E1, E2, ..., E6 du registre à décalage 10. Les étages E1, E2, E3 correspondent à une photodiode d'une ligne et d'une colonne. Les étages E4, E5, E6 correspondent à une photodiode de la même ligne, mais de la colonne suivante. Seuls les étages E1 et E4 sont communs au registre à décalage et aux moyens de transfert 19 parmi les étages représentés.

Sur la figure 3B on a représenté le contenu du registre à décalage après un premier transfert des charges d'entraînement et de charges stockées, dans le puits de potentiel P1, P4 communs à des moyens de transfert et aux étages E1 et E4 du registre à décalage. Après ce premier transfert, le puits de potentiel P1 contient une quantité de charges QA1=QE+QS1 par exemple la charge QS1 provient de l'une des diodes d'une ligne et d'une colonne prédéterminées. De la même manière, un autre puits de réception P4 correspondant à une autre photodiode de la ligne considérée, mais de la colonne suivante de la matrice, contient une quantité de charges QB1=QE+QS2.

Le diagramme de la figure 3C représente schématiquement le contenu du registre à décalage, après un premier décalage vers la droite, des charges QA1 et QA2 qui étaient contenues dans les puits de réception correspondant à chacune des photodiodes. Les charges QA1 et QB1 à mesurer, qui étaient contenues dans l'étage E1 et dans l'étage E4 du registre à décalage sont maintenant respectivement contenues dans le puits de potentiel de l'étage E2 et de l'étage E5 du registre à décalage ; le puits de potentiel de réception de l'étage E1 et de l'étage E4 recoivent par décalage, des étages respectifs précédents (dans l'exemple représenté sur la figure) ou par injection latérale, des nouvelles quantités QE de charges d'entraînement.

Le diagramme de la figure 3D représente schématiquement le contenu du registre à décalage après un deuxième transfert dans les puits de réception P1, P4 de charges d'entraînement QE et de charge QS'1 et QS'2 stockées. Après ce deuxième transfert, les puits de potentiel de réception P1 et P4 des étages E1 et E4 contiennent respectivement les quantités de charges QA2=QE+QS'1 et QB2=QE+QS'2.

La figure 3E représente schématiquement le contenu du registre à décalage, après un deuxième décalage vers la droite. Les quantités de charges QA2 et QB2 qui étaient contenues respectivement dans les puits de potentiel des étages E1 et E4 du registre passent respectivement dans les puits de potentiel ; des étages E2 et E5. Les quantités de charges QA1 et QB1 qui étaient respectivement contenues dans les puits de potentiel des étages E2 et E5 passent dans les puits de potentiel des étages E3 et E6.

Les puits de potentiel de réception des étages E1 et E4 recoivent à nouveau des quantités de charges QE, soit par décalages de charges d'entraînement provenant de l'étage précédent, soit par injection latérale.

La figure 3F représente schématiquement le contenu du registre à décalage après un troisième transfert de charges d'entraînement QE et de charges QS"1 et QS"2 qui étaient stockées dans les puits de stockage des moyens de stockage. Après ce troisième transfert, les puits de réception P1 et P4 des étages E1 et E4 du registre à décalage contiennent respectivement les quantités de charges QA3=QE+QS"1 et QB3=QE+QS"2. Tous les puits de potentiel du registre à décalage sont alors occupés par les charges ainsi transférées pour chaque diode à partir des moyens de stockage correspondants, après trois transferts et deux décalages. On suppose bien entendu que trois transferts sont nécessaires pour chaque diode pour transférer, vers le registre à décalage, toutes les charges accumulées par cette diode pendant une période de balayage de ligne. Ce nombre de transferts et le nombre de décalages qui lui est associé, dépendent bien entendu des caractéristiques des photodiodes utilisées, de l'éclairement maximum de la matrice et de la période de balayage ligne. Lorsque tous les puits de potentiel du registre ont ainsi été occupés par les charges progressivement transférées pour les diodes de ligne considérée, les quantités de charges contenues dans les puits de potentiel sont lues, enregistrées et cumulées par les moyens de lecture, à la suite des décalages successifs des charges, vers l'extrémité de lecture du registre. Le nombre de puits de potentiel correspondant aux charges que l'on souhaite mesurer pour chaque diode étant connu, il est facile grâce aux moyens de lecture, de mesurer les charges telles que $QA1+QA2+QA3$ cumulées pour chaque diode. Il n'est plus nécessaire, comme c'était le cas dans l'état de la technique, de vider complétement le registre à décalage après chaque transfert de charges et plusieurs fois par ligne.

En fait, dans l'exemple décrit, le registre à décalage comporte deux étages successifs tels que E2 et E3 pour chaque diode, pour créer deux puits intermédiaires, entre les puits de potentiel de réception P1 et P4 correspondant respectivement à la diode considérée et à la diode voisine, pour la ligne considérée. La quantité de charges contenues dans chaque puits de stockage correspondant à une diode est prise en compte après trois transferts et deux décalages. D'une manière générale, s'il est nécessaire d'effectuer n transferts, $n > 1$, pour prendre en compte les charges stockées pour chaque diode, le registre à décalage comporte pour cette diode, n étages successifs de décalages. n-1 de ces étages créent n-1 puits de potentiel entre le puits de potentiel de réception pour la diode considérée et le puits de potentiel de réception pour la diode voisine, et un étage supplémentaire commun au registre à décalage et au moyen de transfert correspondant. Cet étage commun crée le puits de potentiel de réception de la diode considérée. La lecture du contenu du registre, pour une ligne ou une colonne, peut être effectuée après n transferts de charges vers le registre et n-1 décalages. Ces transferts successifs de charges au cours de la même période de balayage, accroissent la rapidité du dispositif et permettent d'éviter la saturation des photodiodes et le phénomène de "blooming" mentionné plus haut.

**Revendications**

1. Dispositif de lecture des quantités de charges électriques fournies par des photodiodes (1) à substrat semi-conducteur disposées aux intersections de lignes et de colonnes (4, 5) d'une matrice, comportant un ensemble (6), des moyens de stockage (8) pour créer dans le substrat (2) des photodiodes, des puits de potentiel de stockage correspondant respectivement à chaque colonne ou à chaque ligne, pour stocker successivement ligne par ligne ou colonne par colonne, les charges provenant respectivement des photodiodes de chaque ligne ou chaque colonne, un registre à décalage (10) à transfert de charge et à substrat semi-conducteur (9), ce registre comportant des moyens de commande (11) pour créer des puits de potentiel et des potentiels de transfert dans le substrat du registre à décalage, pour faire circuler des charges électriques dans ce registre, vers une extrémité de sortie (12) de ce registre couplée à des moyens de lecture (13) de quantités de charges et pour chaque moyen (8) de stockage de charges, un moyen de transfert (16) de charges à substrat semi-conducteur (9), ce moyen de transfert étant muni de moyens de commande (18) pour créer dans ce dernier substrat des potentiels de transfert et un puits de potentiel de réception des charges contenues dans le puits de stockage correspondant, les puits de potentiel de réception des moyens de transfert (16) correspondant aux différents puits de stockage étant aussi des puits de potentiel du registre à décalage (10) et des moyens (20) d'injection de charges d'entraînement dans les puits de potentiel de réception, les moyens de commande de chaque moyen de transfert (16) provoquant le transfert des charges d'entraînement contenues dans le puits de réception de ce moyen de transfert, vers le puits de stockage correspondant, puis le transfert de charges d'entraînement et d'au moins une partie des charges stockées dans le puits de stockage vers le puits de réception, caractérisé en ce que le registre à décalage (10) comporte pour chaque photodiode (1) n étages successifs, n étant un nombre entier supérieur à un, n-1 de ces étages créant n-1 puits de potentiel intermédiaires entre le puits de potentiel de réception correspondant à ladite photodiode et la photodiode voisine pour la même ligne ou la même colonne, et un étage commun au registre à décalage (10) et au moyen de transfert (16) correspondant à ladite photodiode et créant ledit puits de potentiel de réception, la quantité de charges contenues dans chaque puits de stockage étant prise en compte par le registre à décalage (10) après un nombre n de transferts de charges stockées et de charges d'entraînement vers le registre à décalage (10) et un nombre n-1 de décalages, les moyens d'injection de charge d'entraînement injectant des charges d'entraînement dans tous les puits de potentiel de réception du registre à décalage avant chaque transfert de charges vers ces puits de réception, la quantité de charges à lire pour chaque photodiode étant lue après n transferts de charges stockées.

2. Dispositif de lecture selon la revendication 1, caractérisé en ce que les moyens d'injection (20) de charges d'entraînement sont des moyens parallèles de transfert de charges d'entraînement qui injectent respectivement ces charges d'entraînement en quantités égales dans les puits de potentiel de réception, avant tout transfert de ces charges d'entraînement vers les puits de potentiel de stockage correspondants.

3. Dispositif de lecture selon la revendication 1, caractérisé en ce que les moyens d'injection de charges d'entraînement sont des moyens de transfert (17) qui injectent ces charges d'entraînement à une extrémité d'entrée du registre à décalage, opposée à l'extrémité de sortie (12) pour que, par décalages successifs, tous les puits de potentiel du registre contiennent respectivement des charges d'entraînement en quantités égales, avant le premier transfert de charges d'entraînement vers les puits de potentiel de stockage, une quantité supplémentaire de charges d'entraînement étant injectée à l'extrémité d'entrée après chaque décalage qui suit un transfert de charges d'un puits de stockage vers un puits de réception.

4. Dispositif de lecture selon la revendication 1 pour lire des quantités de charges électriques fournies par des photodiodes (1) de type P réalisées sur un premier substrat semi-conducteur (2) de type N, caractérisé en ce que lesdits moyens de stockage (8) sont de type P réalisés sur le premier substrat, et en ce que ledit registre de décalage est réalisé sur un deuxième substrat (9) de type P.

5. Dispositif de lecture selon la revendication 1 pour lire des quantités de charges électriques fournies par des photodiodes (1) de type N réalisées sur un substrat semi-conducteur (2) de type P caractérisé en ce que lesdits moyens de stockage (8) sont de type N, réalisés sur le substrat des photodiodes, et en ce que ledit registre de décalage est réalisé sur un substrat (9) de type P.

**Patentansprüche**

1. Lesevorrichtung für von auf einem Halbleitersubstrat ausgebildeten Photodioden (1) gelieferte elektrische Ladungsmengen, die an den Schnittpunkten von Zeilen und Spalten (4, 5) einer Matrix liegen, mit einer Gruppe (6) von Speichermitteln (8), um in dem Substat (2) der Photodioden Potentialsenken entsprechend jeder Spalte bzw. jeder Zeile zu erzeugen, um nacheinander Zeile für Zeile oder Spalte für Spalte die von den Photodioden jeder Zeile bzw. jeder Spalte kommenden Ladungen zu speichern, mit einem Ladungstransfer- Schieberegister (10) auf einem Halbleitersubstrat (9), wobei das Register Steuermittel (11) aufweist, um Potentialsenken und Transferpotentiale im Substrat des Schieberegisters zu erzeugen, um elektrische Ladungen in diesem Register zu einem Ausgangsende (12) dieses Registers zu verschieben, das an Mittel (13) zum Lesen von Ladungsmengen gekoppelt ist, wobei weiter für jedes Ladungsspeichermittel (8) ein Ladungstransfermittel (16) vorgesehen ist, das ein Halbleitersubstrat (9) besitzt und mit Steuermitteln (18) versehen ist, um in dem letztgenannten Substrat Transferpotentiale und ein Senkenpotential für den Empfang der in den entsprechenden Speichersenken enthaltenen Ladungen zu erzeugen, wobei die Empfangspotentialsenken der Transfermittel (16), die den verschiedenen Speichersenken entsprechen, außerdem Potentialsenken für das Schieberegister (10) sind, und wobei das Schieberegister weiter Mittel (20) zur Injektion von Treiberladungen in die Empfangspotentialsenken besitzt, wobei die Steuermittel jedes Transfermittels (16) den Transfer der Treiberladungen, die sich in den Empfangssenken dieses Transfermittels befinden, zur entsprechenden Speichersenke und dann den Transfer von Treiberladungen und mindestens einen Teil der in den Speichersenken gespeicherten Ladungen zu den Empfangssenken bewirken, dadurch gekennzeichnet, daß das Schieberegister (10) für jede Photodiode (1) n aufeinanderfolgende Stufen besitzt, wobei n eine ganze Zahl größer 1 ist und n-1 dieser Stufen n-1 Zwischenpotentialsenken zwischen der dieser Photodiode entsprechenden Empfangspotentialsenke und der benachbarten Photodiode für dieselbe Zeile oder dieselbe Spalte bilden, und daß eine dem Schieberegister (10) und dem Transfermittel (16) entsprechend dieser Photodiode gemeinsame Stufe vorgesehen ist, die die Empfangspotentialsenke erzeugt, wobei die Menge der in jeder Speichersenke enthaltenen Ladungen vom Schieberegister (10) nach n Übertragungen von gespeicherten Ladungen und von Treiberladungen zum Schieberegister (10) und nach n-1 Verschiebungen berücksichtigt wird, wobei die Mittel zur Injektion der Treiberladungen in alle Empfangspotentialsenken des Schieberegisters vor jedem Ladungstransfer in Richtung auf diese Empfangssenken Treiberladungen injizieren und wobei die zu lesende Ladungsmenge für jede Photokathode nach n Übertragungen von gespeicherten Ladungen gelesen wird.

2. Lesevorrichtung nach Anspruch 1, dadurch gekennzeichnet, daß die Injektionsmittel (20) für die Treiberladungen parallele Treiberladungs-Transfermittel sind, die diese Treiberladungen in gleichen Mengen in jede dieser Empfangspotentialsenken vor jedem Transfer dieser Treiberladungen in die entsprechenden Speicherpotentialsenken injizieren.

3. Lesevorrichtung nach Anspruch 1, dadurch gekennzeichnet, daß die Treiberladungs-Injektionsmittel Transfermittel (17) sind, die diese Treiberladungen von einem Eingangsende her, das dem Ausgangsende (12) entgegengesetzt ist, in das Schieberegister injizieren, sodaß durch aufeinanderfolgendes Shiften alle Potentialsenken des Registers Treiberladungen in gleichen Mengen enthalten, ehe der erste Transfer von Treiberladungen in die Speicherpotentialsenken erfolgt, wobei eine zusätzliche Menge von Treiberladungen an das Eingangsende des Schieberegisters nach jeder Verschiebung, die einem Ladungstransfer von einer Speichersenke zu einer Empfangssenke folgt, injiziert wird.

4. Lesevorrichtung nach Anspruch 1 zum Lesen von elektrischen Ladungsmengen, die von Photodioden (1) vom P-Typ geliefert werden, welche auf einem ersten Halbleitersubstrat (2) vom N-Typ ausgebildet sind, dadurch gekennzeichnet, daß die Speichermittel (8) vom P-Typ und auf dem erste Substrat ausgebildet sind und daß das Schieberegister auf einem zweiten Substrat (9) vom P-Typ realisiert ist.

5. Lesevorrichtung nach Anspruch 1 zum Auslesen von elektrischen Ladungsmengen, die von Photodioden (1) vom N-Typ geliefert werden, welche auf einem Halbleitersubstrat (2) vom P-Typ ausgebildet sind, dadurch gekennzeichnet, daß die Speichermittel (8) vom N-Typ und auf dem Substrat der Photodioden ausgebildet sind und daß das Schieberegister auf einem Substrat (9) vom P-Typ realisiert ist.

**Claims**

1. Device for reading the quantities of electrical charges supplied by semiconductor-substrate photodiodes (1) which are disposed at the intersections of rows and columns (4, 5) of a matrix, comprising an assembly (6) of storage means (8) for creating, in the substrate (2) of the photodiodes, storage potential wells corresponding respectively to each column and to each row, in order to store in succession, row by row or column by column, the charges coming respectively from the photodiodes of each row or each column, a semiconductor-substrate (9) charge-transfer shift register (10), this register comprising control means (11) for creating potential wells and transfer wells in the substrate of the shift register, in order to cause electrical charges to flow into this register, towards an output end (12) of this register, which output end is coupled to means (13) for reading quantities of charges and for each charge-storage means (8), a semiconductor-substrate (9) charge-transfer means (16), this transfer means being provided with control means (18) for creating, in the latter substrate, transfer potentials and a potential well for receiving the charges contained in the corresponding storage well, the reception potential wells of the transfer means (16) corresponding to the various storage wells also being potential wells of the shift register (10) and means (20) for injecting drive charges into the reception potential wells, the means for controlling each transfer means (16) resulting in the transfer of the drive charges contained in the reception wells of this transfer means towards the corresponding storage well, then the transfer of drive charges and of at least a portion of the charges stored in the storage well towards the reception well, characterised in that the shift register (10) comprises, for each photodiode (1), n successive stages, n being an integer greater than one, n - 1 of these stages creating n - 1 intermediate potential wells between the reception potential well corresponding to said photodiode and the adjacent photodiode for the same row or the same column, and a stage common to the shift register (10) and to the transfer means (16) corresponding to the said photodiode and creating the said reception potential well, the quantity of charges contained in each storage well being taken into account by the shift register (10) after a number n of transfers of stored charges and of drive charges towards the shift register (10) and a number n - 1 of shifts, the drive-charge injection means injecting drive charges into all the reception potential wells of the shift register before each transfer of charges towards these reception wells, the quantity of charges to be read for each photodiode being read after n transfers of stored charges.

2. Read device according to Claim 1, characterised in that the drive-charge injection means (20) are parallel drive-charge transfer means which inject respectively these drive charges in equal quantities into the reception potential wells before any transfer of these drive charges towards the corresponding storage potential wells.

3. Read device according to Claim 1, characterised in that the drive-charge injection means are transfer means (17) which inject these drive charges at an input end of the shift register, which input end is opposite the output end (12), in order that, by successive shifts, all the potential wells of the register contain respectively drive charges in equal quantities, before the first transfer of drive charges towards the storage potential wells, an additional quantity of drive charges being injected at the input end after each shift which follows a transfer of charges from a storage well towards a reception well.

4. Read device according to Claim 1, to read the quantities of electrical charges supplied by P-type photodiodes (1) which are produced on a first, N-type semiconductor substrate (2), characterised in that the said storage means (8) are of P type and produced on the first substrate and, in that the said shift register is produced on a second, P-type substrate (9).

5. Read device according to Claim 1, to read the quantities of electrical charges supplied by N-type photodiodes (1) which are produced on a P-type semiconductor substrate (2), characterised in that the said storage means (8) are of N type and produced on the substrate of the photodiodes and, in that the said shift register is produced on a P-type substrate (9).

# FIG.1

EP 0 334 735 B1

FIG. 2 A

FIG. 2 B

FIG. 2C

FIG. 2 D

FIG. 2E

12

FIG.3A

FIG.3B

FIG.3C

FIG.3D

FIG.3E

FIG.3F

10  CE  E1 E2 E3 E4 E5 E6  $Q_E$ DANS CHAQUE PUITS  V

$Q_E$  $Q_E$  1° TRANSFERT DE CHARGES STOCKEES ET DE CHARGES D'ENTRAINEMENT

P1 QA1  P4 QB1  1° DECALAGE

$Q_E$ QA1 QB1  2° TRANSFERT DE CHARGES STOCKEES ET DE CHARGES D'ENTRAINEMENT

P1 QA2 QA1 $Q_E$ P4 QB2 QB1  2° DECALAGE

$Q_E$ QA2 QA1 $Q_E$ QB2 QB1  3° TRANSFERT DE CHARGES STOCKEES ET DE CHARGES D'ENTRAINEMENT

P1 QA3 QA2 QA1 P4 QB3 QB2 QB1